# EUROPÄISCHE PATENTANMELDUNG

(11) **EP 4 645 150 A1**
(43) Veröffentlichungstag der Anmeldung: **05.11.2025**
(21) Anmeldenummer: 25168755.4
(22) Anmeldetag: 07.04.2025
(51) Int. Cl.: G06F 30/20, G06N 20/00

(54) **VERFAHREN ZUR VALIDIERUNG DIGITAL MANIPULIERTER (AUGMENTIERTER) TEST-SZENARIEN**

(30) Priorität: 02.05.2024 DE 102024112338
(71) Anmelder: AVL Software And Functions GmbH, 93059 Regensburg (DE)
(72) Erfinder: Hofmeister, Justus, 93059 Regensburg (DE); Kerejewski, Tino, 93059 Regensburg (DE)
(74) Vertreter: Hannke, Christian

(57) **Zusammenfassung**

Die Erfindung betrifft Verfahren 100 zur Validierung digital manipulierter (augmentierter) Test-Szenarien 120, mit den Schritten eines digitalen Aufzeichnens eines Basis-Szenarios 110, mit wenigstens einem realen Fahrzeug 200, 210, das sich auf einem realen Fahrweg unter definierten realen Verkehrsbedingungen bewegt; eines digitalen Aufzeichnens des um ausgewählte Verkehrsbedingungen 310 manipulierten Basis-Szenarios 110 zum Erstellen eines Referenz-Szenarios 130; eines Manipulierens der Daten des digital aufgezeichneten Basis-Szenarios 110 um ausgewählte Verkehrsbedingungen 310' zum Erstellen eines erweiterten Test-Szenarios 120; eines Erfassens von Daten der Verkehrsbedingungen in dem erweiterten Test-Szenario 120 und von Daten in dem Referenz-Szenario 130 mit wenigstens einem Sensor; eines Analysierens 140 der Wechselbeziehung zwischen den mit dem wenigstens einen Sensor erfassten Test- und Referenzdaten, und eines Bewertens 150 einer Gültigkeit der Daten des Test-Szenarios basierend auf einem Ergebnis des Analysierens 140 der Wechselbeziehung. Die Erfindung betrifft weiterhin ein entsprechendes computerimplementiertes Verfahren sowie bevorzugte Verwendungen des Verfahrens.

## Beschreibung

Die Erfindung betrifft das technische Gebiet der Simulationstechnik und insbesondere ein Verfahren zur Validierung digital manipulierter (augmentierter) Test-Szenarien gemäß Anspruch 1, ein entsprechendes computerimplementiertes Verfahren gemäß Anspruch 10, sowie bevorzugte Verwendungen des Verfahrens gemäß Anspruch 15.

Die Validierung von Funktionen zur Sensierung von Umgebungsdaten für automatisierte Fahrsysteme (Automated Driving System, ADS) erfordert einen hohen Testaufwand, unter anderem unter Verwendung simulierter oder aufgezeichneter Testdaten (Teststimuli) verschiedener Szenarien. Sensoralgorithmen im Sinne der 'Sense-Plan-Act'-Aufteilung automatisierter Fahrstapel werden bei allen Aspekten der Erfassung und Verarbeitung von Umweltinformationen berücksichtigt. Da Simulationen derzeit nicht ausreichend repräsentativ sind, sind meist reale Aufnahmen auf Basis von Open-World-Fahrten und / oder Testgeländen verwendbar. Die Erfassung realer Daten ist mit hohem Aufwand verbunden und hängt stark von nicht beeinflussbaren Parametern wie Wetter oder Lichtverhältnissen ab.

Eine Aufgabe der vorliegenden Erfindung besteht deshalb darin, diese Nachteile zu umgehen und realistische sowie einfach herstellbare Testdaten zur Simulation von autonomen Fahrzeugen bereitzustellen.

Diese Aufgabe wird gelöst durch ein Verfahren zur Validierung digital manipulierter (augmentierter) Test-Szenarien gemäß Anspruch 1. Das erfindungsgemäße Verfahren umfasst die Schritte eines digitalen Aufzeichnens eines Basis-Szenarios, mit wenigstens einem realen Fahrzeug, das sich auf einem realen Fahrweg unter definierten realen Verkehrsbedingungen bewegt; eines digitales Aufzeichnens des um ausgewählte Verkehrsbedingungen manipulierten Basis-Szenarios zum Erstellen eines Referenz-Szenarios; eines Manipulierens der Daten des digital aufgezeichneten Basis-Szenarios um ausgewählte Verkehrsbedingungen zum Erstellen eines erweiterten Test-Szenarios; eines Erfassens von Daten der Verkehrsbedingungen in dem erweiterten Test-Szenario und von Daten in dem Referenz-Szenario mit wenigstens einem Sensor; eines Analysierens der Wechselbeziehung zwischen den mit dem wenigstens einen Sensor erfassten Test- und Referenzdaten, und eines Bewertens einer Gültigkeit der Daten des Test-Szenarios basierend auf einem Ergebnis des Analysierens der Wechselbeziehung.

Das Analysieren der Wechselbeziehung zwischen den mit dem wenigstens einen Sensor erfassten Test- und Referenzdaten kann dabei auch das Vergleichen eines Systemverhaltens nach Anwendung der Teststimuli (real / digital) auf ein ADS umfassen. In diesem Fall wird geprüft, inwieweit die Erkennungsfunktionen zur Erfassung von Umgebungsdaten zum gleichen Systemverhalten führen.

Ein wesentlicher Punkt des erfindungsgemäßen Verfahrens besteht darin, die Nutzung der aufgezeichneten realen Daten zu maximieren, indem die verfügbaren Daten in Bezug auf bestimmte Parameter digital manipuliert werden oder erweitert (augmentiert) werden. Bei dieser 'Data Augmentation' wird die reale Aufzeichnung dahingehend manipuliert, dass einzelne Parameter verändert werden, um zusätzliche Instanzen der aufgezeichneten Daten zu erzeugen. Dieses Verfahren erhöht die verfügbaren Testdaten bei vertretbarem Aufwand deutlich.

Vorteilhafte Weiterbildungen des erfindungsgemäßen Verfahrens sind in den Unteransprüchen angegeben.

In einer ersten vorteilhaften Ausführungsform des erfindungsgemäßen Verfahrens ist es vorgesehen, dass die Verkehrsbedingungen Wetterbedingungen, wie beispielsweise Niederschlag, Lichtverhältnisse, und / oder Fahrwegbedingungen, wie beispielsweise Art, Verlauf und Beschaffenheit eines Fahrwegs, Objekte wie Fahrzeuge oder Personen, Regelungen wie Verkehrsschilder oder Lichtzeichen, umfassen. Damit lassen sich unterschiedlichste Test-Szenarien entwickeln und gegen Referenz-Szenarien analysieren.

In einer zweiten bevorzugten Ausführungsform des erfindungsgemäßen Verfahrens umfassen die ausgewählten Verkehrsbedingungen ein Hinzufügen des Effekts von Niederschlag, insbesondere von Nebel, Nieselregen, Regenschauern, Graupel und / oder Schnee, womit eine Palette von Niederschlägen bereitsteht, welche üblicherweise eine besondere Herausforderung an die Erkennungsfunktionen eines Fahrzeugs zur Vermeidung kritischer Fahrsituationen stellt.

In einer weiteren bevorzugten Ausführungsform des erfindungsgemäßen Verfahrens wird ein digitales Rauschen und Helligkeitsänderungen zum Erzeugen des Effekts ausgewählter Verkehrsbedingungen hinzugefügt, was insbesondere eine besonders einfache Simulation von Niederschlägen zulässt.

Zwar können damit grundsätzlich alle Wetterbedingungen simuliert werden. Es ist aber darüber hinaus auch von Vorteil, wenn die ausgewählten Verkehrsbedingungen ein Hinzufügen des Effekts von weiteren Objekten, wie weiteren Fahrzeugen und / oder Personen umfassen, um auch Simulationen spezifischer Verkehrsbedingungen zuzulassen.

In einer weiteren bevorzugten Ausführungsform des erfindungsgemäßen Verfahrens umfasst das digitalisierte Aufzeichnen des Basis- und / oder Referenz-Szenarios bildgebende und / oder abstandsgebende Daten, die insbesondere durch Kamerabilder und / oder LIDAR(Light Detection And Ranging)-Punktewolken und / oder Radar (Radio Detection And Ranging) hergestellt werden. Dadurch liegen besonders genaue Referenzdaten vor, die eine Analyse des Test-Szenarios verbessern.

In einer weiteren bevorzugten Ausführungsform des erfindungsgemäßen Verfahrens wird ausgehend von der Analyse der Wechselbeziehung zwischen den Daten des Test-Szenarios und denen des Referenz-Szenarios eine Bewertung (Validierung) der Gültigkeit der Daten des Test-Szenarios durchgeführt. Damit kann festgestellt werden, inwieweit die Daten des Testszenarios für eine Simulation der realen Verkehrsbedingungen tatsächlich verwendbar sind.

In einer weiteren bevorzugten Ausführungsform des erfindungsgemäßen Verfahrens wird zum Bewerten der Gültigkeit der Daten des Test-Szenarios eine Übereinstimmung mit der Norm ISO 21448-2022 (szenario and system analysis) festgestellt, die eine Bewertung der Testdaten nach einem definiertem Maßstab zulässt, der auch eine spätere Zertifizierung der Simulation und / oder der Erkennungsfunktionen erlaubt.

Zur Validierung der Daten des Test-Szenarios wird eine Bewertung von deren Gültigkeit, wie vorstehend beschrieben, berücksichtigt. Um das Test-Szenario dem Referenz-Szenario schließlich näher zu bringen, werden in einer weiteren bevorzugten Ausführungsform des erfindungsgemäßen Verfahrens ausgehend dieser Bewertung der Daten des Test-Szenarios die Daten der ausgewählten Verkehrsbedingungen dann entsprechend manipuliert (optimiert).

Zum einen kann damit das Test-Szenario wie vorstehend beschrieben optimiert werden. Stimmen Test-Szenario und Referenz-Szenario aber ausreichend überein, beispielsweise weil die Testdaten gültig nach Norm ISO 21448-2022 zu beurteilen sind, so ist es bevorzugt, auch erfassungsbezogene Algorithmen des wenigstens einen Sensors für autonome Fahrzeuge zu manipulieren, um die Erkennungsleistung des wenigstens einen Sensors zu verbessern.

Die vorstehende Aufgabe wird auch durch ein computerimplementiertes Verfahren zur Validierung digital manipulierter (augmentierter) Test-Szenarien gemäß Anspruch 10 gelöst, bei dem ein Computer zur Aufnahme eines Basis- und Referenzszenarios mit wenigstens einem bild- und / oder abstandsgebenden Sensor kommuniziert, und das Basis-Szenario um ausgewählte Verkehrsbedingungen zur Erstellung eines erweiterten Test-Szenarios manipuliert, und zur Erfassung von Daten der Verkehrsbedingungen in dem Referenz-Szenario und dem erweiterten Test-Szenario mit dem wenigstens einen Sensor kommuniziert, und eine Wechselbeziehung zwischen den mit dem wenigstens einen Sensor in dem Test-Szenario aufgezeichneten Daten und den von dem wenigstens einen Sensor in dem Referenz-Szenario aufgezeichneten Referenzdaten der Verkehrsbedingungen analysiert und bewertet.

Ein wesentlicher Punkt des erfindungsgemäßen computerimplementierten Verfahrens besteht dabei darin, dass es weitgehend automatisiert ablaufen kann und damit eine erheblichen Zeitvorteil gegenüber gängigen Open-World-Fahrten und / oder Testgeländen aufweist.

Vorteilhafte Weiterbildungen des erfindungsgemäßen computerimplementierten Verfahrens sind in den Unteransprüchen angegeben.

In einer ersten bevorzugten Ausführungsform des computerimplementierten Verfahrens wird zum Bewerten (150) der Gültigkeit der Daten des Test-Szenarios eine Übereinstimmung mit der Norm ISO 21448-2022 (szenario and system analysis) festgestellt, was eine Einhaltung festgelegter Standards und in der Folge eine entsprechende Zertifizierung eines autonomen Fahrzeugs erlaubt.

In einer zweiten bevorzugten Ausführungsform des computerimplementierten Verfahrens werden ausgehend von der Bewertung einer Gültigkeit der Daten des Test-Szenarios die Daten der ausgewählten Verkehrsbedingungen manipuliert, was eine Automatisierung dieses Schrittes mit einem weiteren Zeitvorteil und einer definierten Validierung dieser Daten ermöglicht.

In einer weiteren bevorzugten Ausführungsform des computerimplementierten Verfahrens werden ausgehend von der Analyse erfassungsbezogene Algorithmen des wenigstens einen Sensor für autonome Fahrzeuge manipuliert. Dies geschieht insbesondere dann, wenn die Daten des Test-Szenarios als gültig bewertet werden, und der wenigstens ein Sensor in seiner Erkennungsleistung weiter optimiert werden soll.

In einer weiteren bevorzugten Ausführungsform des computerimplementierten Verfahrens wird eine Optimierung des Test-Szenarios und / oder erfassungsbezogener Algorithmen des wenigstens einen Sensor durch eine selbstlernende Algorithmik, insbesondere basierend auf maschinellem Lermen und / oder neuronalen Netzen unterstützt wird. Damit lässt sich auch in diesem Optimierungsschritt ein Zeitvorteil erlangen, der auf selbstlernende Systeme zurückgeht.

Grundsätzlich ist die Nutzung des erfindungsgemäßen Verfahrens für Simulationen einer großen Varianz von unterschiedlichsten Verkehrsbedingungen möglich. Gerade deshalb soll es bevorzugt zur Optimierung von erweiterten Test-Szenarien Optimierung von Sensoren und / oder erweiterten Test-Szenarien für autonome Fahrsysteme verwendet werden.

Weitere Vorteile, Ziele und Eigenschaften der vorliegenden Erfindung werden anhand nachfolgender Beschreibung der anliegenden Figuren erläutert. Gleichartige Komponenten können in den verschiedenen Ausführungsformen gleiche Bezugszeichen aufweisen. Bei den Figuren zeigen:
- Fig.1: ein Funktionsschaltbild eines erfindungsgemäßen Verfahrensablaufs zur Validierung digital manipulierter (augmentierter) Test-Szenarien;
- Fig. 2: eine detailliertere Darstellung der Gegenstände aller Schritte des Verfahrensablaufs nach Figur 1, und
- Fig. 3: eine Gegenüberstellung der Gegenstände von Basis-, Test- und Referenz-Szenario.

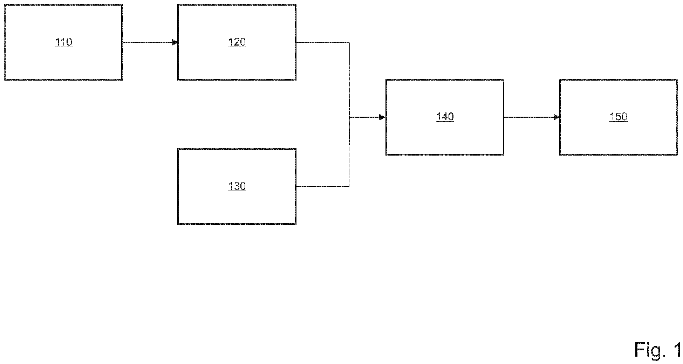

Die Figur 1 zeigt ein Funktionsschaltbild eines erfindungsgemäßen Verfahrensablaufs 100 zur Validierung eines digital manipulierten (augmentierten) Test-Szenarios 120. Im Schritt 110 wird dabei ein reales Basis-Szenario von Verkehrsbedingungen digital aufgezeichnet, und in einem darauffolgenden Schritt 120 zu einem Test-Szenario digital erweitert. Dabei wird ein Parameter x der Daten des digitalen Test-Szenarios durch Erweiterung auf einen bestimmten Wert geändert. Als Referenz-Szenario 130 wird das reale Basis-Szenario 110 digital aufgezeichnet, das aber mit dem Parameter x auf dieselben spezifischen Verkehrsbedingungen wie für das erweiterte Test-szenario 120 verändert wurde. In einem weiteren Schritt 140 wird die Wechselbeziehung zwischen den Teststimuli des Test-Szenarios 120 und den Daten des Referenz-Szenarios 130 analysiert, und nachfolgend eine Gültigkeit der erweiterten Testdaten bewertet. Dabei wird hier auch das Systemverhalten nach Anwendung der Teststimuli (real / digital) auf ein ADS miteinander verglichen, das heißt überprüft, inwieweit die Erkennungsfunktionen zur Erfassung von Umgebungsdaten zum gleichen Systemverhalten führen. Werden diese als gültig sind, beispielweise mit Blick auf die SOTIF (Safety Of The Intended Functionality)-Validierung der Norm ISO 21448-2022, kann das Test-Szenario für die Simulation eines Sensors, insbesondere für einen bildgebenden und / oder abstandsmessenden Sensor, verwendet werden. Für diesen Validierungsansatz ist also ein bestimmtes Erkennungssystem erforderlich.

Der Validierungsansatz basiert damit auf der Verwendung einer realen Testumgebung mit hoher Reproduzierbarkeit. Zur Validierung werden die Wechselbeziehungen zwischen nahezu identischen Szenarien sowohl in der realen Welt als auch mit erweiterten Daten analysiert. Das Validierungsargument und die Beweise für die Datenerweiterung hinsichtlich spezifischer Parameter in repräsentativen Szenarien können als Beweise in einem verallgemeinerten Validierungsargument für erweiterte Daten verwendet werden.

Der Mechanismus der Datenerweiterung ist ein Schlüsselmechanismus zur Vervielfachung vorhandener realer aufgezeichneter Daten für die Validierung von Sensoralgorithmen. Um diesen Mechanismus für die SOTIF-Validierung gemäß Norm ISO 21448-2022 nutzen zu können, muss ein Argument für die Gültigkeit und Angemessenheit inklusive Nachweis des Mechanismus vorgelegt werden. Der vorstehend beschriebene Validierungsansatz unterstützt nachdrücklich das SOTIF-Argument und ist ein wertvolles Produkt im Kontext des autonomen Fahrens auf dem europäischen Markt, wie auch ein Sicherheitsargument im Kontext des autonomen Fahrens auf dem internationalen Markt.

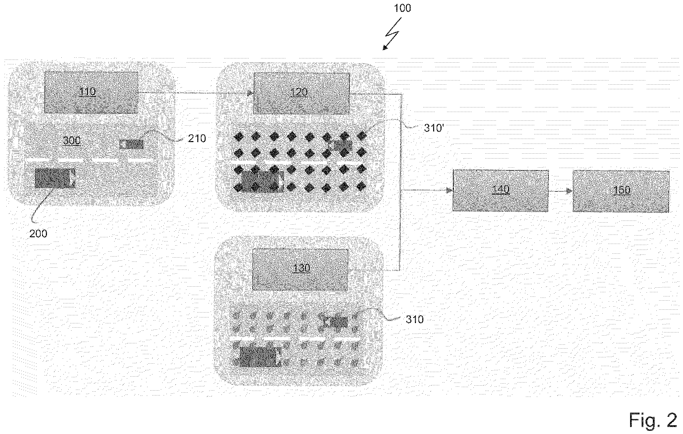

Die Figur 2 zeigt eine detailliertere Darstellung der Gegenstände aller Schritte des Verfahrensablaufs nach Figur 1. In dem Schritt 110 wird zur Bildung eines digitalen Basis-Szenarios ein Fahrweg 300 mit einem EGO(Autonomen)-Fahrzeug 200 auf einer Spur, und einer PRU (Protected Road User), hier einem Fahrzeug 210 auf einer parallelen Spur, die sich aufeinander zubewegen.

In dem weiteren Schritt 120 wird ein Test-Szenario durch digitale Erweiterung von ausgewählten Verkehrsbedingungen 310', hier Niederschlag durch Hinzufügung von digitalem und Rauschen und Helligkeitsminderung erstellt. Schließlich wird in dem Schritt 130 ein Referenz-Szenario mit digital aufgezeichneten ausgewählten Verkehrsbedingungen 310 , hier realem Niederschlag, zum Abgleich gegen das Test-Szenario aufgezeichnet.

In dem weiteren Schritt 140 wird eine Wechselbeziehung zwischen den Teststimuli des Test-Szenarios und den Daten des Referenz-Szenarios analysiert, und die Gültigkeit der Daten in dem darauffolgenden Schritt 150 bewertet. Sind diese beispielsweise gegenüber Norm ISO 21448-2022 ungültig, geben die Daten die ausgewählten realen Verkehrsbedingungen nicht realistisch wieder. Die Daten wären demnach zu optimieren, beispielsweise durch entsprechendes Manipulieren des digitalen Rauschens und der Helligkeit. Dieser Vorgang kann auch durch selbstlernende System wie neuronale Netze unterstützt werden, deren Trainingsdaten die erweiterten Daten des Test-Szenarios und die Daten des Referenz-Szenarios umfassen.

Grundsätzlich können als Basis-Szenario dabei reale Aufzeichnungen dienen, wie beispielsweise Kamerabilder und / oder LIDAR-Punktwolken eines Szenarios bei leicht bewölkten Wetterbedingungen. Diesen aufgezeichneten Daten werden digitales Rauschen und Helligkeitsänderungen hinzugefügt, um im Test-Szenario den Effekt von Regen oder Nebel zu erzeugen. Dies führt zu einem Fall des Basisszenarios mit veränderten Wetterbedingungen.

Ein dem entsprechender Verfahrensablauf sieht vor, ein Basisszenario ohne Niederschlag in O-pen-World-Fahrten und / oder Testgeländen digital aufzuzeichnen. Danach wird ein Referenz-Szenario, genau das gleiche Szenario wie das Basis-Szenario mit einer bestimmten Niederschlagsmenge, in Open-World-Fahrten und / oder Testgeländen digital aufgezeichnet. Schließlich wird das aufgezeichnete Basis-Szenario (ohne Niederschlag) durch Hinzufügen von digitalem Rauschen erweitert, um Niederschlag zu simulieren. Abschließend wird die Wechselbeziehung zwischen Referenz-Szenario und des erweiterten Basis-Szenarios analysiert, um die Gültigkeit der Erweiterung zu bewerten.

Als Basis können aber auch reale Aufzeichnungen dienen, wie beispielsweise Kamerabilder und / oder LIDAR-Punktwolken eines kreuzungsbezogenen Szenarios mit einer PRU wie zum Beispiel einem Fahrzeug. Die Informationen, welche die PRU darstellen, bei der Kamera die Pixel, bei dem LIDAR die Punktwolkenpartition, können extrahiert und an einer anderen Position in das Szenario wieder eingesetzt werden, um eine andere PRU innerhalb des Szenarios zu simulieren. Dadurch entsteht eine weitere Instanz des Basisszenarios mit einer zusätzlichen PRU.

Ein dem entsprechender Verfahrensablauf sieht hier vor, dass ein Basis-Szenario mit einem Fahrzeug n Meter vor dem EGO-Fahrzeug, mittig auf der Gegenfahrbahn, in Open-World-Fahrten und / oder Testgeländen digital aufgezeichnet wird. Danach wird ein Referenz-Szenario, und zwar genau das gleiche Szenario wie das Basis-Szenario digital aufgezeichnet, aber das Fahrzeug mittig auf der Mittelspurmarkierung in Open-World-Fahrten und / oder Testgeländen platziert. Schließlich wird das aufgezeichnete Basis-Szenario durch virtuelles / digitales Bewegen des Fahrzeugs mittig auf der Mittelspurmarkierung erweitert, um eine Objektbewegung zu simulieren. Schließlich wird eine Wechselbeziehung zwischen dem Referenz-Szenarios und dem erweiterten Basis-Szenarios analysiert, um die Gültigkeit der Erweiterung zu bewerten.

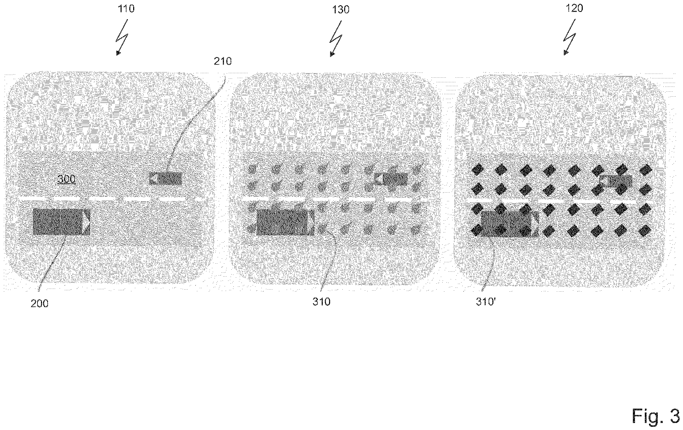

Die Figur 3 zeigt eine Gegenüberstellung der Gegenstände von Basis-, Test- und Referenz-Szenario aus den Schritten 110, 120 und 130. Das EGO-Fahrzeug 200 und das auf einer parallelen Gegenspur des Fahrwegs 300 entgegenkommende Fahrzeug 210 bewegen sich mit einer Geschwindigkeit von 20 km/h aufeinander zu. Das reale Basis-Szenario wird ohne ausgewählte Verkehrsbedingungen 310, hier realer Regen, digital aufgezeichnet. Im Referenz-Szenario des Schrittes 130 wurde das Basis-Szenario mit dem realen Regen digital aufgezeichnet, das schließlich mit dem Test-Szenario des Schrittes 120 verglichen wird. Im Test-Szenario wurde der Regel digital hinzugefügt, beispielsweise durch digitales Rauschen und Helligkeitsänderung. Eine Wechselbeziehung zwischen den Daten des Test-Szenarios und den Daten des Referenz-Szenarios wird schließlich analysiert, also untersucht, ob die Daten geeignet sind, dem wenigstens einen eingesetzten Sensor ein gleiches Situationsbild zu vermitteln. Ist dies der Fall, können die Testdaten als gültig bewertet und für weitere Sensorversuche genutzt werden, beispielweise zur Optimierung der Sensorleistung.

Das vorstehend beschriebene Verfahren zur Datenanreicherung kann zur Generierung von Teststimuli verwendet werden. Um jedoch gültige Testergebnisse zu generieren, die das Verhalten der Sensoralgorithmen in der realen Welt widerspiegeln, muss ein Argument für die Gültigkeit der erweiterten Daten geliefert werden. Dieses Argument kann auf repräsentativen Stichprobenvalidierungen basieren, welche die Wechselbeziehung der erweiterten Daten mit realen Daten vergleichen. Dafür müssen exakt die gleichen Szenarien (Augmented und Real World) verfügbar sein. Aufgrund der hohen Reproduzierbarkeitsfähigkeiten können mit eingerichteten Testgeländen genaue Nachbildungen erweiterter Szenarien erstellt werden, um zuverlässige Daten für die Korrelationsanalyse bereitzustellen.

### Bezugszeichenliste

- 100: Verfahren zur Validierung digital augmentierter Test-Szenarien
- 110: Aufzeichnung eines Basis-Szenarios
- 120: Aufzeichnung eines erweiterten Test-Szenarios
- 130: Aufzeichnung eines Referenz-Szenarios
- 140: Analysieren der Wechselbeziehung zwischen Test- und Referenzdaten
- 150: Bewertung der Gültigkeit Sensordaten von Test-Szenario
- 200: EGO (Autonomes)-Fahrzeug
- 210: weiteres Fahrzeug
- 300: Fahrweg
- 310: Ausgewählte Verkehrsbedingungen im Referenz-Szenario
- 310': Ausgewählte Verkehrsbedingungen im Test-Szenario

## Patentansprüche

1. Verfahren (100) zur Validierung digital manipulierter (augmentierter) Test-Szenarien (120), mit den Schritten:
Digitales Aufzeichnen eines Basis-Szenarios (110), mit wenigstens einem realen Fahrzeug (200, 210), das sich auf einem realen Fahrweg unter definierten realen Verkehrsbedingungen bewegt;
Digitales Aufzeichnen des um ausgewählte Verkehrsbedingungen (310) manipulierten Basis-Szenarios (110) zum Erstellen eines Referenz-Szenarios (130);
Manipulieren der Daten des digital aufgezeichneten Basis-Szenarios (110) um ausgewählte Verkehrsbedingungen (310') zum Erstellen eines erweiterten Test-Szenarios (120);
Erfassen von Daten der Verkehrsbedingungen in dem erweiterten Test-Szenario (120) und dem Referenz-Szenario (130) mit wenigstens einem Sensor;
Analysieren (140) der Wechselbeziehung zwischen den mit dem wenigstens einen Sensor erfassten Test- und Referenzdaten, und
Bewerten (150) einer Gültigkeit der Daten des Test-Szenarios basierend auf einem Ergebnis des Analysierens (140) der Wechselbeziehung.

2. Verfahren (100) nach Anspruch 1, **dadurch gekennzeichnet, dass** die Verkehrsbedingungen Wetterbedingungen, wie beispielsweise Niederschlag (310, 310'), Lichtverhältnisse, und / oder Fahrwegbedingungen, wie beispielsweise Art, Verlauf und Beschaffenheit eines Fahrwegs (300), Objekte wie Fahrzeuge (200, 210) oder Personen, Regelungen wie Verkehrsschilder oder Lichtzeichen, umfassen.

3. Verfahren (100) nach Anspruch 1 oder 2, **dadurch gekennzeichnet, dass** die ausgewählten Verkehrsbedingungen (310') ein Hinzufügen des Effekts von Niederschlag, insbesondere von Nebel, Nieselregen, Regenschauern, Graupel und / oder Schnee umfassen.

4. Verfahren (100) nach einem der vorstehenden Ansprüche, **dadurch gekennzeichnet, dass** ein digitales Rauschen und Helligkeitsänderungen zum Erzeugen des Effekts ausgewählter Verkehrsbedingungen (310') hinzugefügt wird.

5. Verfahren (100) nach einem der vorstehenden Ansprüche, **dadurch gekennzeichnet, dass** die ausgewählten Verkehrsbedingungen (310, 310') ein Hinzufügen des Effekts von weiteren Objekten, wie weiteren Fahrzeugen (210) und / oder Personen umfassen.

6. Verfahren (100) nach einem der vorstehenden Ansprüche, **dadurch gekennzeichnet, dass** das digitalisierte Aufzeichnen des Basis- (110) und / oder Referenz-Szenarios (130) bildgebende und / oder abstandsgebende Daten umfasst.

7. Verfahren (100) nach einem der vorstehenden Ansprüche, **dadurch gekennzeichnet, dass** zur Bewertung der Gültigkeit (150) der Daten des Test-Szenarios eine Übereinstimmung mit der Norm ISO 21448 (szenario and system analysis) festgestellt wird.

8. Verfahren (100) nach einem der vorstehenden Ansprüche, **dadurch gekennzeichnet, dass** ausgehend von der Bewertung (150) einer Gültigkeit der Daten des Test-Szenarios die Daten der ausgewählten Verkehrsbedingungen (310') manipuliert werden.

9. Verfahren (100) nach einem der vorstehenden Ansprüche, **dadurch gekennzeichnet, dass** ausgehend von der Analyse (140) der Wechselbeziehung zwischen den Daten des Test-Szenarios (120) und denen des Referenz-Szenarios (130) erfassungsbezogene Algorithmen des wenigstens ein Sensor für autonome Fahrzeuge manipuliert werden.

10. Computerimplementiertes Verfahren (100) nach einem der vorstehenden Ansprüche zur Validierung digital manipulierter (augmentierter) Test-Szenarien (120), bei dem ein Computer zur Aufnahme eines Basis- (110) und Referenzszenarios (130) mit wenigstens einem bild- und / oder abstandsgebenden Sensor kommuniziert, und das Basis-Szenario (110) um ausgewählte Verkehrsbedingungen (310') zur Erstellung eines erweiterten Test-Szenarios (120) manipuliert, zur Erfassung von Daten der Verkehrsbedingungen in dem Referenz-Szenario (130) und dem erweiterten Test-Szenario (120) mit dem wenigstens einen Sensor kommuniziert, und eine Wechselbeziehung zwischen den mit dem wenigstens einen Sensor in dem Test-Szenario (120) erfassten Daten und den von dem wenigstens einen Sensor in dem Referenz-Szenario (130) erfassten Daten der Verkehrsbedingungen analysiert (140) und bewertet (150).

11. Computerimplementiertes Verfahren (100) nach Anspruch 10, **dadurch gekennzeichnet, dass** zum Bewerten (150) der Gültigkeit der Daten des Test-Szenarios (120) eine Übereinstimmung mit der Norm ISO 21448-2022 (szenario and system analysis) feststellt wird.

12. Computerimplementiertes Verfahren nach Anspruch 10 oder 11, **dadurch gekennzeichnet, dass** ausgehend von der Bewertung (150) einer Gültigkeit der Daten des Test-Szenarios die Daten der ausgewählten Verkehrsbedingungen (310') manipuliert werden.

13. Computerimplementiertes Verfahren (100) nach einem der Ansprüche 10 bis 12, **dadurch gekennzeichnet, dass** ausgehend von der Analyse (140) erfassungsbezogene Algorithmen des wenigstens eines Sensors für autonome Fahrzeuge manipuliert werden.

14. Computerimplementiertes Verfahren (100) nach einem der Ansprüche 10 bis 13, **dadurch gekennzeichnet, dass** eine Optimierung des Test-Szenarios und / oder erfassungsbezogener Algorithmen des wenigstens eines Sensors durch eine selbstlernende Algorithmik, insbesondere basierend auf maschinellem Lermen und / oder neuronalen Netzen unterstützt wird.

15. Verwendung des Verfahrens nach einem der Ansprüche 1 bis 9 zur Optimierung von erweiterten Test-Szenarien und / oder Sensoren für autonome Fahrsysteme.
